# DEMANDE DE BREVET EUROPEEN

(11) **EP 1 816 674 A1**
(43) Date de publication de la demande: **08.08.2007**
(21) Numéro de dépôt: 07101313.0
(22) Date de dépôt: 29.01.2007
(51) Int. Cl.: H01L 21/3065, H01J 37/32

(54) **Procédé de gravure anisotropique**

(30) Priorité: 01.02.2006 FR 0650357
(71) Demandeur: Alcatel Lucent, 75008 Paris (FR)
(72) Inventeur: Puech, Michel, 74370, METZ-TESSY (FR)
(74) Mandataire: Sciaux, Edmond

(57) **Abrégé**

La présente invention a pour objet un procédé de gravure anisotropique d'un substrat de silicium a très basse température par plasma de gaz fluoré à haute densité, caractérisé en ce que le plasma est formé à partir d'un mélange de gaz comprenant un gaz de gravure contenant du fluor, un gaz de passivation contenant de l'oxygène et un gaz de réaction comprenant du chlore, et dans lequel les rapports respectifs du débit du gaz de passivation et du débit du gaz de réaction au débit du gaz de gravure sont inférieurs à 0,15 en volume. De préférence le gaz de gravure contenant du fluor est l'hexafluorure de soufre SF₆, le gaz de passivation contenant de l'oxygène est choisi parmi l'oxygène O₂, l'ozone O₃ et le dioxyde de soufre SO₂ et le gaz de réaction comprenant du chlore est te tétrachtorure de silicium SiCl₄.

## Description

La présente invention se rapporte à un procédé de gravure anisotropique à très basse température par plasma de gaz fluoré à haute densité pour réaliser des microreliefs à la surface des substrats semi-conducteurs, notamment des substrats en silicium pour la réalisation de composants à semi-conducteurs, de microsystèmes électromécaniques (MEMS) ou de microsystèmes électro-optoméca niques (MOEMS).

Les microsystèmes nécessitent des gravures profondes hautement anisotropiques tout en maintenant une sélectivité élevée et des grandes vitesses d'attaque. Des techniques à base de chimies non toxiques, non corrosives et simples sont préférables.

Classiquement, un plasma de gaz de gravure à base de fluor est utilisé pour générer un maximum d'ions et d'atomes de fluor permettant des vitesses d'attaque élevées du silicium. Les ions et atomes de fluor sont connus pour réagir spontanément, de manière exothermique, avec le silicium en provoquant une attaque isotropique. Cependant pour une plus grande précision, on cherche à obtenir un motif dont les parois soient le plus verticales possible. Une gravure anisotropique au moyen d'un gaz fluoré nécessite donc la protection des flancs du motif gravé par dépôt d'une couche de passivation afin de favoriser l'attaque dans le fond du motif tout en protégeant les côtés, L'utilisation de gaz à base d'autres halogènes que le fluor, tels que le chlore, le brome ou l'iode, permet une attaque anisotropique du silicium, mais au prix de vitesse d'attaque très lente ce qui les rend rarement utilisés en pratique. Le problème posé est donc d'améliorer l'anisotropie de la gravure, sans augmenter la durée de l'opération de gravure. Des solutions alternatives ont été proposées

Une première méthode, dite « procédé pulsé », a été proposée et décrite notamment dans le document US-5,501,893, selon laquelle on alterne les phases de gravure du substrat et de dépôt de la couche de passivation. Au cours d'une première étape un gaz de gravure, par exemple un mélange SF₆ et argon, est envoyé sur le substrat suivi au cours d'une seconde étape par un gaz de passivation, par exemple un mélange C₄F₈ ou CHF₃ et argon, qui dépose une couche de polymère sur les parois du motif gravé.

Cependant, cette technique possède plusieurs inconvénients, comme celui d'être salissante et très sensible au conditionnement des parois du réacteur. D'une part le temps nécessaire pour ôter le film en fond de tranchée induit un temps de procédé qui n'est pas utilisé pour l'attaque du silicium, ce qui entraîne une augmentation de la durée totale de l'étape de gravure du substrat. De même la sélectivité est réduite par la projection d'ions énergétiques qui attaquent également le masque de gravure. D'autre part l'utilisation d'un gaz fluoro-carboné comme le C₄F₈ est onéreuse. Enfin l'alternance des phases de gravure et de dépôt génère des ondulations sur les flancs de gravure.

L'autre méthode proposée est celle dite « procédé continu » qui consiste à ajouter au gaz de gravure un gaz favorisant la formation de polymères de manière à déposer une couche de polymère sur toute la surface du substrat mise à nu par la gravure. Le gaz de passivation est le plus souvent un gaz fluoro-carboné et une couche du type CₓF_{y} ou COₓF_{y} est alors déposée sur la surface du substrat. Après enlèvement du film de polymère protecteur dans le fond de la cavité par bombardement vertical par le plasma, l'attaque se fait sélectivement dans le fond de la cavité. La passivation évite ainsi que le plasma de gaz de gravure ionisé attaque les parois latérales de la cavité. Ainsi, malgré le caractère isotrope de l'attaque du silicium par un plasma de gaz de gravure tel qu'un gaz fluoré, on obtient une gravure quasi-anisotrope du silicium.

Cette technique est notamment illustrée par le document WO-99/67 817 qui décrit un procédé de gravure profonde du silicium. Ce procédé utilise une combinaison de gaz réactifs comprenant un gaz contenant du fluor mais pas de silicium (FC), un gaz contenant du silicium, et de préférence aussi du fluor (SC), et de l'oxygène (O₂) dans des proportions fixées dont dépend la sélectivité. Une moindre quantité d'un autre gaz halogéné peut être ajoutée. Dans le cas où le gaz SC contient du silicium et du fluor, on a les rapports volumiques: FC/SC = 25 à 0,1 et O₂/FC = 10 à 0,1. Ce mélange de gaz est par exemple un mélange de SF₆ (FC) + SiF₄ (SC) + O₂, Du fait de l'exothermicité de la réaction le substrat doit être refroidi, et sa température maintenue entre 70°C et 140°C.

Une autre méthode est décrite par le document US-2004/0,097,090 qui propose un procédé utilisant un mélange d'un gaz fluoré contenant du carbone ou du soufre, d'un gaz fluoré contenant du silicium et de l'oxygène, comme par exemple un mélange SF₆/SiF₄/O₂. Le rapport de la concentration de l'oxygène à celle du gaz fluoré contenant du carbone ou du soufre est compris entre 0,2 etO,8. La concentration du gaz fluoré contenant du silicium représente au moins 10% du mélange total. Pour une gravure d'au moins 20µm, les débits des gaz composant le mélange sont dans le rapport suivant : gaz fluoré contenant du carbone ou du soufre/oxygène/gaz fluoré contenant du silicium 0,8 à 2,4/0,16 à 0,96/1. Durant l'opération de gravure la température du porte-échantillon est comprise entre -30°C et +20°C.

Cependant la maîtrise de l'effet de chaque gaz nécessite un contrôle précis des paramètres du procédé, comme par exemple la pression partielle de choque gaz, la puissance de la source de plasma et/ou la polarisation du substrat. En outre ce procédé est très sensible à l'état des parois de la chambre de traitement. La pollution entraînée par la présence d'un gaz formant un polymère nécessite de prévoir une opération de nettoyage après l'opération de gravure, ce qui ralentit le procédé.

Une voie différente est décrite dans l'article « Low temperature etching of Si and PR in high density plasma » de M. PUECH et Ph. MAQUIN (Appl. Surf. Sc., 100/101, (1996),579-582). Ce procédé de gravure profonde (>50µm), dit « procédé cryogénique », combine l'ajout d'une faible quantité d'oxygène dans un gaz de gravure fluoré, comme SF₆, et l'abaissement de la température de la surface du substrat, autour de -100°C. Le maintien à basse température de la surface du substrat est indispensable pour obtenir l'anisotropie en contribuant à la formation d'une couche de passivation, du type silico-oxygénée SiO et/ou silico-fluorée SiF, ou bien d'une fine couche de SiGₓF qui protège les parois verticales du motif gravé. A une température de-100°C en l'absence d'oxygène, l'attaque du silicium par SF₆ est toujours isotrope. Ainsi avec une température de substrat très froide, il est possible d'obtenir des profils anisotropiques même avec de petites quantités de flux de gaz oxygéné. Pour une proportion d'oxygène trop importante on observe la formation de « black silicon ». Le « black silicon » est une détérioration du fond du motif constitué de fines dendrites et porosités, au lieu d'un fond de motif habituellement lisse, qui ont été provoquées par une passivation trop importante des surfaces. La formation de « black silicon » bloque la gravure verticale du silicium de manière aléatoire et doit donc être évitée.

Les auteurs ont observé qu'il est impossible d'obtenir une attaque anisotrope à une température de + 10°C même en augmentant la proportion d'oxygène ajouté. En effet, pour garder la même qualité d'anisotropie, les procédés de gravure à température ambiante sont soumis à des conditions de rapport volumétrique de gaz beaucoup plus élevées impliquant notamment de forts flux de gaz oxygénés. Le plasma de gaz oxygéné induit une perte de sélectivité du fait de ses capacités bien connues de gravure du masque de résine. Pour garder une sélectivité acceptable, l'application des procédés continus de gravure anisotropique à température ambiante doit alors être limitée aux masques de type « hardmask » à base de matériaux inorganiques (WO 99/67817).

L'inconvénient de ce procédé de gravure anisotropique à très basse température est que la plage de régulation des paramètres du procédé est trop étroite, notamment la température, la pression partielle des gaz et la tension de polarisation du substrat. Par exemple, le procédé nécessite que la température de la surface du substrat soit contrôlée à 0,5°C près, ce qui est difficile à réaliser. Si la température est trop basse, un basculement à l'état de « black silicon » peut être observé. D'autres paramètres du procédé comme la quantité d'oxygène introduite dans le mélange de gaz ou l'énergie de bombardement peuvent aussi créer le « black silicon » s'ils sont mal optimisés. Si la pression partielle de gaz oxygéné varie à plus ou moins 2% du débit initial, le régime de la gravure peut basculer soit en sous-passivation, soit en sur-passivation (« black silicon »).

Si un paramètre est mal optimisé, le procédé n'est plus parfaitement anisotropique. Le silicium peut se dépassiver en certains endroits, notamment sur les parties hautes des profils particulièrement sensibles car exposées plus longtemps au bombardement ionique du plasma. Les ions qui n'ont pas une trajectoire parfaitement verticale peuvent déplacer ou casser les liaisons SiOₓF_{y} et des « trous » peuvent apparaître créant des défauts. Ces défauts sont plus ou moins importants selon la taille des motifs.

Enfin le moindre écart de régulation de la température du substrat peut entraîner l'un ou l'autre de ces états qui auront pour effet de produire des profils qui ne seront pas parfaitement anisotropes. Or le porte-substrat est uniforme en température à mieux que ±1°C, et on n'attend plus aujourd'hui de progrès du point de vue de la conception mécanique susceptible d'améliorer encore cette uniformité, Par ailleurs, même si la température du porte-substrat est parfaitement régulée, la température de surface du substrat peut subir des variations pouvant atteindre 1°C compte tenu des variations possibles des états de surface d'un substrat à l'autre (la face arrière du substrat pouvant ou non comporter une couche d'oxyde plus ou moins épaisse) et de la géométrie des échantillons.

La présente invention a pour but de proposer un procédé de gravure anisotropique du silicium à très basse température qui ne présente pas les inconvénients du procédé connu.

En particulier le procédé proposé permet une fenêtre de variation plus large des paramètres du procédé, notamment la température de la surface du substrat, tout en préservant le caractère anisotropique et la qualité de la gravure.

L'objet de la présente invention est un procédé de gravure anisotropique du silicium à très basse température par plasma de gaz fluoré à haute densité, caractérisé en ce que le plasma est formé à partir d'un mélange de gaz comprenant (a) un gaz de gravure contenant du fluor, (b) un gaz de passivation contenant de l'oxygène et (c) un gaz de réaction comprenant du chlore, et dans lequel les rapports respectifs du débit du gaz de passivation et du débit du gaz de réaction au débit du gaz de gravure sont inférieurs à 0,15 en volume.

Selon un premier aspect de l'invention, les rapports respectifs du débit du gaz de passivation et du débit du gaz de réaction au débit du gaz de gravure sont compris entre 0,01 et 0,10 en volume.

De préférence le rapport du débit du gaz de passivation au débit du gaz de gravure est compris entre 0,02 et 0,08 en volume.

De préférence le rapport du débit du gaz de réaction au débit du gaz de gravure est compris entre 0,01 et 0,08 en volume.

Selon un deuxième aspect de l'invention, le débit d'introduction du gaz de gravure est de préférence compris entre 0,20 l/mn et 0,40 l/mn, soit 200 sccm à 400 sccm (sccm : standard cubic centimeters per minute).

Le débit d'introduction du gaz de passivation et du gaz de réaction est compris de préférence entre 0,001 l/mn et 0,030 1/mn, soit 1 sccm à 30 sccm.

De préférence le débit d'introduction du gaz de passivation est compris entre 0,010 l/mn et 0,030 l/mn, soit 10 sccm à 30 sccm.

De préférence le débit d'introduction du gaz de réaction est compris entre 0,005 l/mn et 0,015 l/mn, soit 5 sccm à 15 sccm.

Selon un troisième aspect de l'invention, la température de la surface du substrat est inférieure à -70°C. De préférence la température de la surface du substrat est comprise entre -80°C et -110°C.

Selon un quatrième aspect de l'invention, le gaz de gravure contenant du fluor est l'hexafluorure de soufre SF₆.

Le gaz de réaction peut être également un gaz passivant. De préférence le gaz de réaction comprenant du chlore est le tétrachlorure de silicium SiCl₄.

Le gaz de passivation contenant de l'oxygène est choisi de préférence parmi l'oxygène O₂, l'ozone O₃ et le dioxyde de soufre SO₂. Avantageusement on utilisera un gaz ayant des propriétés oxydantes plus élevées que l'oxygène O₂, comme par exemple l'ozone O₃ et le dioxyde de soufre SO₂.

L'invention a aussi pour objet un dispositif pour la mise en oeuvre du procédé de gravure anisotropique d'un substrat de silicium à très basse température par plasma de gaz fluoré à haute densité décrit précédemment. Ce dispositif comprend:
- une chambre de procédé sous vide,
- une source de génération de plasma par couplage inductif,
- d'un porte-substrat muni de moyens de refroidissement du substrat qu'il porte,
- des moyens de contrôle et de gestion de la température du substrat,
- au moins trois lignes d'admission de gaz à débit réglable pour l'introduction respectivement d'un gaz de gravure contenant du fluor, d'un gaz de passivation contenant de l'oxygène et d'un gaz de réaction comprenant du chlore.
   Selon un mode particulier de réalisation de l'invention, le gaz de réaction est introduit à la sortie du tube de la source de plasma en direction de la chambre de procédé. De préférence le gaz de réaction est introduit dans la chambre de procédé.
   Dans ce cas le dispositif comporte des moyens d'injection du gaz de réaction comprenant un anneau torique percé de plusieurs orifices.
   Le procédé selon l'invention vise à renforcer ou à assurer l'intégrité de la couche de passivation qui protége les flancs de la gravure tout au long de l'étape de gravure afin de la rendre moins sensible aux variations des paramètres du procédé. En effet cette couche très fragile est notamment à l'origine des défauts irréversibles crées au cours de la gravure par les procédés de l'art antérieur. La couche de passivation obtenue par le procédé selon la présente invention a la particularité de se sublimer facilement quand la température augmente au-delà de-70°C. Cette propriété de la couche de passivation confère au procédé l'avantage d'être un procédé de gravure très propre en évitant la présence de polluants de type C, CₓF_{y} ou téflon comme les procédés de l'art antérieur. Les parois des chambres restent propres et les surfaces des substrats sont donc toujours propres. Industriellement, c'est un avantage important car les étapes de nettoyage, mécanique ou par plasma, de ces chambres ne sont plus nécessaires. De ce fait la disponibilité de ces chambres est augmentée et il n'est plus nécessaire de prévoir un système spécifique chauffant en vue du nettoyage.
   D'autres avantages découlent de ce procédé. Le réglage des paramètres de procédé devient plus simple, ainsi il devient possible d'élargir la plage de température de la surface du substrat. La totalité du temps d'opération est consacré à la gravure, ce qui permet d'atteindre intrinsèquement des vitesses de gravure élevées. Pour un même type de motif à graver, on a montré qu'une vitesse de gravure de 2,92µm/min pouvait être atteinte par le procédé selon l'invention au lieu de 1,45µm/min obtenu avec un procédé de l'art antérieur, dit « procédé pulsé ».
   Les motifs à très hauts facteurs de forme nécessitent un contrôle de l'anisotropie pendant des durées plus longues que les procédés de gravure micronique, et sur des profondeurs qui peuvent être de plusieurs centaines de microns. Le procédé de gravure à très basse température selon l'invention permet de ne pas dégrader la résine du masque de gravure, alors plus longuement exposée au plasma.
   D'autres caractéristiques et avantages de la présente invention apparaîtront au cours de la description suivante de mode de réalisation, donnés bien entendu à titre illustratif et non limitatif, et dans le dessin annexé sur lequel
- la figure 1 représente un dispositif pour la mise en oeuvre du procédé selon la présente invention, et
- la figure 2 représente une variante du dispositif de la figure 1,

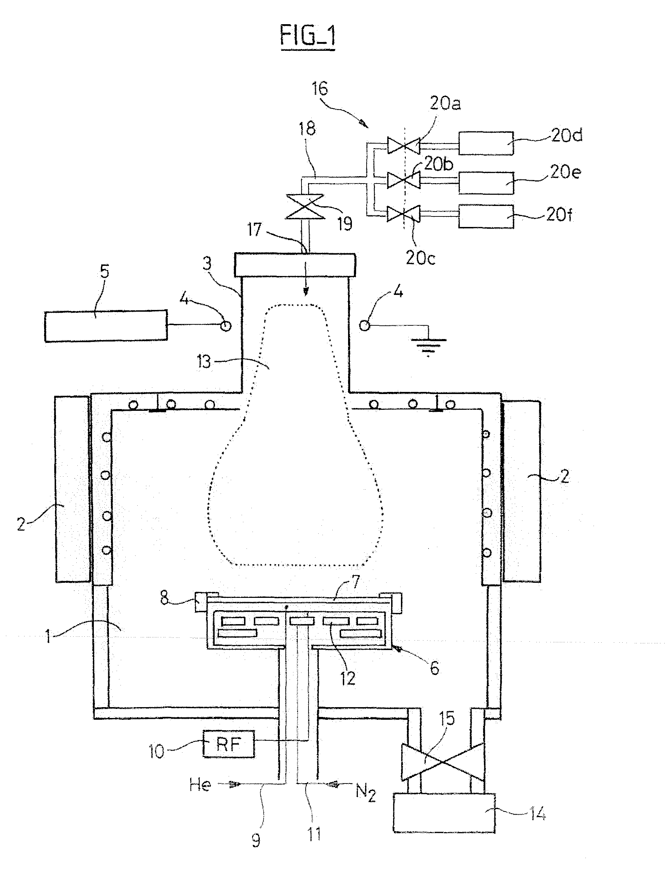

Le dispositif représenté sur la figure 1 est un appareil de gravure par plasma qui comprend une chambre de procédé **1** entourée d'aimants permanents **2** dans une disposition multipolaire de façon à diminuer la perte d'électrons sur les parois de la chambre. La chambre **1** communique avec une source de plasma dont le tube **3** en matériau diélectrique dans lequel se forme le plasma est entouré d'une électrode de couplage **4** alimentée en courant électrique alternatif à fréquence radio par un générateur **5** radiofréquence RF appliquant une puissance P radiofréquence RF (13.56 Mhz) comprise entre 500 W et 2000 W.

La chambre **1** contient un porte-substrat **6.** Un substrat à graver **7** d'une épaisseur d'environ 100mm est fixé sur le porte-substrat **6** par des moyens mécaniques ou électrostatiques, mécaniquement ici par exemple au moyen d'une bague **8.** Le substrat **7** est séparé du porte-substrat **6** par un film d'hélium **9.** Une tension de polarisation U comprise entre 20 V et 60 V, de préférence de l'ordre de 50V, est appliquée au substrat **7** au moyen d'un générateur **10** radiofréquence RF (13.56 Mhz) ou basse fréquence BF (50à500Khz). Le substrat **7** est refroidi par l'intermédiaire de sa face arrière grâce à la circulation d'un liquide réfrigérant **11,** tel que de l'azote (N₂) liquide, dans des canaux **12** ménagés dans le parte-substrat **6.** Un tel système permet de contrôler thermiquement un substrat dans une plage de température qui peut aller de -140°C à +20°C. Le substrat **7** est maintenu à une température T de préférence comprise entre -100°C et -80°C.

L'électrode de couplage **4** excite les gaz dans le tube **3** pour produire un plasma **13** qui se déplace ensuite vers l'intérieur de la chambre de réaction **1** en direction du parte-substrat **6.**

La chambre **1** est reliée à un groupe de pompage secondaire comprenant une pompe turbomoléculaire **14** via un système de régulation **15** de la pression dans la chambre. La pression de travail dans la chambre de procédé **1** est stabilisée et régulée par le système **15** à une valeur comprise entre 2 Pa et 10 Pa. Un système **16** d'introduction et de contrôle des débits permet l'admission des différents gaz, par exemple ici SF₆, O₂ et SiCl₄. Le gaz de passivation, ici O₂, peut être introduit dans la chambre **1** au fur et à mesure du procédé selon une consigne en forme de rampe. Dans le cas présent, le flux de O₂ peut être compris entre 1sccm et 30sccm pour un flux de SF₆ de 240sccm. La quantité de SiCl₄ qui est introduite peut être ajustée en fonction de la géométrie du motif à graver.

Le système d'injection de gaz **16** comprennent une entrée de gaz **17** dans la chambre de procédé **1,** de préférence en amont de la zone de génération de plasma, l'entrée de gaz **17** étant reliée par des canalisations **18** et des vannes d'isolation **19** et de commande de débit de gaz **20a, 20b** et **20c** à une source de gaz de gravure **20d,** une source de gaz de passivation **20e** et une source de gaz de réaction **20f.** La source de gaz de gravure **20d** et les moyens de commande de débit de gaz de gravure **20a,** tels qu'une électrovanne, permettent de piloter l'introduction de gaz de gravure à l'extrémité du tube **3** dans la source de plasma lorsque la vanne d'isolation **19** est ouverte. De même, la source de gaz de passivation **20e** et des moyens de commande de débit de gaz de passivation **20b,** tels qu'une électrovanne, permettent de piloter l'introduction de gaz de passivation à l'extrémité du tube **3** dans la source de plasma lorsque la vanne d'isolation **19** est ouverte. La source de gaz de réaction **20f** et les moyens de commande de débit de réaction **20c,** tels qu'une électrovanne, permettent de piloter l'introduction de gaz de réaction à l'extrémité du tube **3** dans la source de plasma **4** lorsque la vanne d'isolation **19** est ouverte.

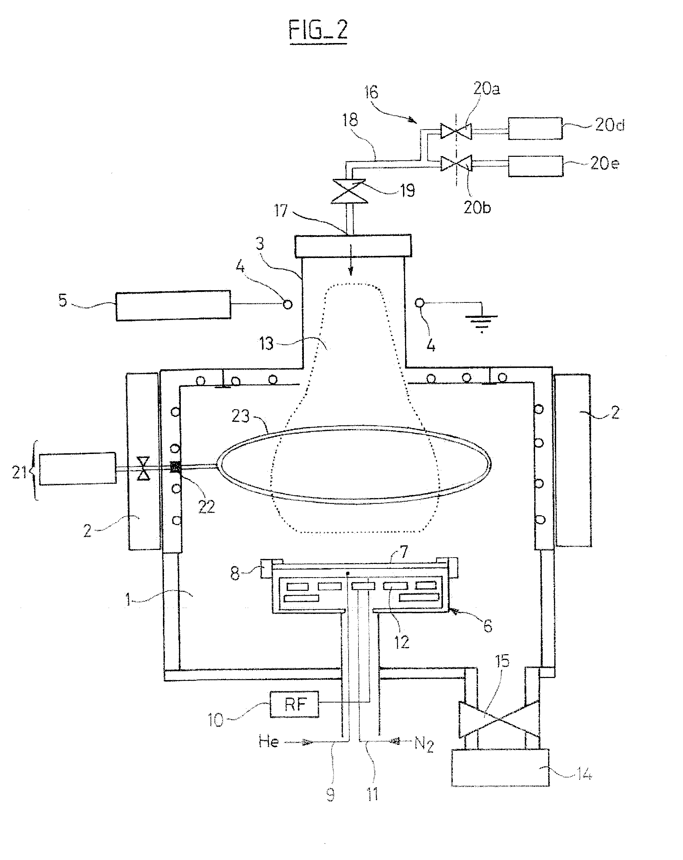

De façon alternative et très avantageuse, comme représenté sur la figure 2, le gaz de réaction est injecté dans une zone « post-décharge» qui est située après source de plasma et directement dans la chambre de procédé **1.** De cette manière, le gaz de réaction va être dissocié au plus proche du substrat **7,** ce qui permet au gaz fragmenté de ne pas se recombiner avant d'atteindre la surface du substrat **7** et d'éviter ainsi de contaminer le substrat **7.** Des moyens d'injection spécifiques du gaz de réaction **21** peuvent être adaptés dans la chambre. Ces moyens peuvent comprendre un orifice **22** dans la paroi de la chambre **1.** De manière privilégiée, les moyens d'injection du gaz de réaction **21** comprennent un anneau torique **23** percé de plusieurs orifices disposés sur son pourtour intérieur.

## Revendications

1. Procédé de gravure anisotropique d'un substrat de silicium à très basse température par plasma de gaz fluoré à haute densité, **caractérisé en ce que** le plasma est formé à partir d'un mélange de gaz comprenant un gaz de gravure contenant du fluor et un gaz de passivation contenant de l'oxygène **caractérisé en ce que** le mélange de gaz contient en outre un gaz de réaction comprenant du chlore et dans lequel les rapports respectifs du débit du gaz de passivation et du débit du gaz de réaction au débit du gaz de gravure sont inférieurs à 0,15 en volume.

2. Procédé selon la revendication 1, dans lequel les rapports respectifs du débit du gaz de passivation et du débit du gaz de réaction au débit du gaz de gravure sont compris entre 0,01 et 0,10 en volume.

3. Procédé selon la revendication 2, dans lequel le rapport du débit du gaz de passivation au débit du gaz de gravure est compris entre 0,02 et 0,08 en volume.

4. Procédé selon la revendication 2, dans lequel le rapport du débit du gaz de réaction au débit du gaz de gravure est compris entre 0,01 et 0,08 en volume.

5. Procédé selon l'une des revendications 1 à 4, dans lequel le débit d'introduction du gaz de gravure est compris entre 0,20 l/mn et 0,40 l/mn .

6. Procédé selon la revendication 1, dans lequel le débit d'introduction du gaz de passivation et du gaz de réaction est compris entre 0,001 l/mn et 0,030 l/mn.

7. Procédé selon la revendication 6, dans lequel le débit d'introduction du gaz de passivation est compris entre 0,010 l/mn et 0,030 l/mn.

8. Procédé selon la revendication 6, dans lequel le débit d'introduction du gaz de réaction est compris entre 4,045 l/mn et 0,015 l/mn.

9. Procédé selon l'une des revendications précédentes, dans lequel la température de la surface du substrat est inférieure à -70°C.

10. Procédé selon la revendication 9, dans lequel la température de la surface du substrat est comprise entre -80°C et -110°C.

11. Procédé selon l'une des revendications précédentes, dans lequel le gaz de gravure contenant du fluor est l'hexafluorure de soufre.

12. Procédé selon l'une des revendications précédentes, dans lequel le gaz de passivation contenant de l'oxygène est choisi parmi l'oxygène, l'ozone et le dioxyde de soufre.

13. Procédé selon l'une des revendications précédentes, dans lequel le gaz de réaction comprenant du chlore est le tétrachlorure de silicium.

14. Dispositif pour la mise en oeuvre d'un procédé de gravure anisotropique d'un substrat (7) de silicium à très basse température par plasma de gaz fluoré à haute densité selon l'une des revendications précédentes, comprenant
- une chambre de procédé (1) sous vide,
- une source de génération de plasma (13) par couplage inductif,
- d'un porte-substrat (6) muni de moyens de refroidissement (11, 12) du substrat qu'il porte,
- des moyens de contrôle et de gestion de la température du substrat,
- au moins trois lignes d'admission de gaz (16) à débit réglable pour l'introduction respectivement d'un gaz de gravure contenant du fluor, d'un gaz de passivation contenant de l'oxygène et d'un gaz de réaction comprenant du chlore.

15. Dispositif selon la revendication 14 dans lequel le gaz de réaction est introduit à la sortie du tube (3) de la source de plasma en direction de la chambre de procédé (1).

16. Dispositif selon la revendication 14 dans lequel le gaz de réaction est introduit dans la chambre de procédé (1).

17. Dispositif selon l'une des revendications 15 et 16, qui comporte des moyens d'injection (21) du gaz de réaction comprenant un anneau torique (23) percé de plusieurs orifices.
